# EUROPÄISCHE PATENTSCHRIFT

(11) **EP 2 201 160 B1**
(45) Veröffentlichungstag und Bekanntmachung des Hinweises auf die Patenterteilung: **31.10.2012**
(21) Anmeldenummer: 09765476.8
(22) Anmeldetag: 08.05.2009
(51) Int. Cl.: C25D 5/08, C25D 7/12, C25D 17/02, C25D 17/06, H01L 31/0224, H01L 31/18, C25D 5/02, C25D 17/00

(54) **VORRICHTUNG UND VERFAHREN ZUR EINSEITIGEN NASSCHEMISCHEN UND/ODER ELEKTROLYTISCHEN BEHANDLUNG VON GUT**
APPARATUS AND PROCESS FOR THE ONE-SIDED WET-CHEMICAL AND/OR ELECTROLYTIC TREATMENT OF MATERIAL
DISPOSITIF ET PROCÉDÉ POUR LE TRAITEMENT UNILATÉRAL PAR VOIE CHIMIQUE HUMIDE ET/OU ÉLECTROLYTIQUE D'UNE MATIÈRE

(30) Priorität: 19.06.2008 DE 102008028847
(43) Veröffentlichungstag der Anmeldung: 30.06.2010
(73) Patentinhaber: RENA GmbH, 78148 Gütenbach (DE)
(72) Erfinder: BÜRGER, Norbert, 79199 Kirchzarten (DE); DELAHAYE, Franck, 79279 Vörstetten (DE); KALTENBACH, Konrad, 78120 Furtwangen (DE)
(74) Vertreter: Stürken, Joachim
(86) Internationale Anmeldenummer: PCT/EP2009/003294
(87) Internationale Veröffentlichungsnummer: WO 2009/152896

(56) Entgegenhaltungen:
- EP-A- 0 434 434
- WO-A-2008/071239
- DE-A1-102007 020 449
- US-A- 5 000 827
- US-A1- 2008 105 555
- US-B1- 6 270 647

## Beschreibung

Die Erfindung betrifft die nasschemische, elektrochemische und elektrolytische Behandlung sowie die Reinigung von ebenem Gut, wie insbesondere von Substraten wie Wafern, Solarzellen, Hybriden, CDs und dergleichen.

Typische Beispiele für Behandlungsverfahren, die sich an eine Oberflächenreinigung anschließen, betreffen das Aktivieren, Dotieren, das elektrochemische/elektrolytische oder chemische Metallisieren oder das Ätzen, Strippen und dergleichen geeigneter Substrate. Normalerweise werden derartige Güter lediglich einseitig an der Oberfläche behandelt. Demgemäß kann sowohl eine vollständige Oberfläche als auch eine strukturierte Behandlung vorliegen. Um eine Beschädigung des Gutes aufgrund chemischer Reaktionen zu vermeiden, muss die nicht zu behandelnde Rückseite gewöhnlich sicher gegen eine durch die Behandlungsflüssigkeit verursachte Benetzung geschützt werden. Hierzu sind so genannte Cup- oder Fountain-Behandlungseinrichtungen bekannt. Der Behandlungsraum derartiger Einrichtungen wird an einer Seite von dem zu behandelnden Gut geschlossen. Während der gesamten Behandlungsdauer ist das Gut z.B. mittels eines Substrathalters, eines Greifers oder einer Spannvorrichtung mit dem Behandlungsraum verbunden. Daher kann die Behandlungsflüssigkeit gegen die zu behandelnde Oberfläche strömen, so dass eine chemische Modifikation des Gutes herbeigeführt werden kann. Dichtelemente, die an den Spannvorrichtungen in der Nähe des Gutes angeordnet sind, verhindern eine Benetzung der nicht zu behandelnden Rückseite. Derartige Dichtelemente können auch gebildet werden durch passende Greifer, Vakuumhalter oder andere Transporteinrichtungen, welche bei Kontaktierung die gesamte Rückseite des Gutes abdecken und somit vor unerwünschter Benetzung schützen. Gewöhnlich können derartige Vorrichtungen beispielsweise mechanisch, mit Vakuum, oder nach dem Bernoulli-Prinzip arbeiten.

Ein typisches Beispiel für eine Vorrichtung zur Behandlung der zuvor genannten Güter beschreibt die Druckschrift WO 99/16936, welche die elektrolytische Metallisierung von Wafern betrifft. Innerhalb des Behandlungsraumes ist eine Anode und, erforderlichenfalls, eine Streublende integriert. Die zu behandelnde Oberfläche des Gutes bildet die Kathode der elektrolytischen Zelle. Der Elektrolyt strömt von unten in den Behandlungsraum ein und verlässt diesen anschließend, indem er über seinen Rand überläuft. Das Gut wird von einem Träger gehalten und kontaktiert, der aus Probenhaltern, Rotoren, Statoren und Einrichtungen zur Stromübertragung und Messung besteht. Das in dieser Weise eingespannte Gut wird während der gesamten Behandlungsdauer mittels einer Transporteinrichtung horizontal und vertikal an der Oberfläche der überströmenden Behandlungsflüssigkeit positioniert und fixiert. Mittels eines präzisen Vertikalantriebs, wie z.B. eines Schrittmotors für den Träger, wird die Eintauchtiefe des Gutes so eingestellt, dass lediglich die zu behandelnde Unterseite benetzt wird und mit der Behandlungsflüssigkeit in Kontakt bleibt. Bei der vorliegenden elektrolytischen Metallisierung werden die elektrisch leitfähigen Probenhalter, die sich an der Unterseite des Gutes befinden, auch metallisiert. Diese unerwünscht metallisierten Halter müssen von Zeit zu Zeit entmetallisiert werden. Hierzu wird der Träger ohne das Gut in einem zusätzlichen Verfahrensschritt derart über dem Behandlungsraum positioniert, dass die metallisierten Teile des Probenhalters in die Behandlungsflüssigkeit eintauchen. Die Probenhalter werden anodisch gegen eine kathodische Hilfselektrode geschaltet. Die Probenhalter werden dann mittels einer Stromquelle elektrolytisch entmetallisiert. Die Hilfselektrode absorbiert das Metall, wie z.B. das Kupfer. Sie muss nach einigen Ätzvorgängen ausgetauscht werden. Diese Vorrichtung nach dem Stand der Technik weist die folgenden Nachteile auf:
Das Gut muss zur Behandlung in einen Träger eingespannt und von diesem während der gesamten Behandlungsdauer gehalten werden. Daher muss die Höhenlage des Gutes in Bezug auf die Behandlungsflüssigkeit individuell ermittelt und mittels eines Vertikalantriebes präzise eingestellt werden. Weil das in der Regel sehr dünne Gut, das beispielsweise eine Dicke von 0,3 mm aufweisen kann, praktisch über dem Behandlungsraum schwebt, ist eine sehr stabile mechanische Konstruktion für den Aufbau des Behandlungsraumes als auch für die Transporteinrichtung und den Träger notwendig. Zukünftig wird die Dicke von Solarzellen aus Silizium auf etwa 0,1 mm reduziert werden. Darüber hinaus kann die Höhenlage des Trägers in Bezug auf die Behandlungsflüssigkeit durch Temperaturveränderungen während der Behandlung beeinflusst werden.

Dem Problem der korrekten Höheneinstellung des Gutes über der Oberfläche des Elektrolyten entspricht die in US 5,429,733 offenbarte Vorrichtung. Das Gut wird mittels Luftkissen über dem Behandlungsraum gehalten, wobei die gesamte Halterung mechanisch mit dem Behandlungsraum verbunden ist. Zugleich wird die nicht nasschemisch zu behandelnde Oberseite des Gutes gegen die Behandlungsflüssigkeit abgedichtet. Nachteilig ist jedoch die Tatsache, dass das Gut zeitaufwändig in die Halterung eingebracht und dort fixiert werden muss. Nach Beendigung der Behandlung muss das Gut aus der Halterung entnommen werden. Bei bruchempfindlichen Gütern, wie z.B. bei Solarzellen aus Silizium, besteht immer die Gefahr eines Bruches der dünnen Scheiben. Gleiches gilt während der eigentlichen Behandlung, wenn die Behandlungsflüssigkeit zu intensiv gegen das eingespannte und damit besonders bruchgefährdete Gut strömt. Eine gegebene minimale Flussrate des in den Behandlungsraum einströmenden Elektrolyten ist jedoch notwendig, um die beschriebene Rückströmung zu überwinden und die Oberfläche des Gutes zur Herbeiführung einer chemischen Modifikation derselben zu kontaktieren. In diesem Zusammenhang und insbesondere im Hinblick auf die künftigen nasschemisch zu behandelnden dünnen Substrate mit zunehmendem Durchmesser wird auch die Gefahr eines Bruches dieser dünnen Güter dramatisch erhöht.

Die gleiche Bruchgefahr besteht unter Verwendung der Vorrichtungen zur nasschemischen und/oder elektrolytischen Behandlung von ebenen Gütern, die in US 5,437,777 und DE 197 36 340 C2 beschrieben sind. Die Güter werden mittels Halterungen in Kontakt mit der Behandlungsflüssigkeit gebracht. Dichtungen schützen sowohl die nicht zu behandelnde Oberseite des Gutes als auch die Kontaktmittel zur Stromeinleitung in die Behandlungsflüssigkeit. Neben der beschriebenen Bruchgefahr für das Gut ist es ferner nachteilig, dass es in die Halterungen eingebracht und nach der Behandlung wieder entnommen werden muss.

Diese Handhabungsprobleme bestehen auch bei der Vorrichtung, welche in US 5,443,707 beschrieben wird. Die Halterungen einer derartigen Vorrichtung müssen während der gesamten Expositionsdauer am Gut verbleiben, und für jedes System sind mehrere dieser technisch komplexen Vorrichtungen erforderlich, um das Gut während der Behandlung zu positionieren. Abstandhalter bestimmen die Höhenlage in Bezug auf die Oberkante des Behälters, gegen die das Gut von dem Halter oder der Transporteinrichtung gedrückt wird. In allen Fällen werden Kräfte auf das Gut ausgeübt, die zum Bruch desselben führen können.

Die Druckschrift US 5,000,827 beschreibt eine elektrolytische Zelle zur partiellen Metallisierung von Wafern. Der vom Boden einströmende Elektrolyt verlässt die Zelle über eine Überlaufkante. Zur Beeinflussung der Strömung, insbesondere im Randbereich der Unterseite des Wafers, erfolgt die Einstellung des Abstandes H mittels Stützelementen in Form von Schrauben. Gleiches gilt für den Abstand S, der vom Durchmesser des Wafers und der elektrolytischen Zelle festgelegt wird und einmalig eingestellt werden muss. Die elektrische Kontaktierung erfolgt an der trockenen Oberseite des Wafers, wodurch das Gut während der elektrolytischen Behandlung mit diesen Kontaktierungsmitteln in Berührung bleibt. Da der Elektrolyt nicht an die elektrischen Kontakte gelangt, werden diese nicht metallisiert. Allerdings müssen beide Seiten des Gutes elektrisch miteinander verbunden sein. In diesem Falle ist eine Entmetallisierung der Kontakte nicht erforderlich.

Die Stützelemente, die zugleich den Wafer gegen eine seitliche Verlagerung über der Zelle fixieren, sind wesentliche Elemente jener Erfindung. In der Praxis zeigt es sich jedoch, dass die Behandlungsflüssigkeit durch derartige seitlich wirkenden Begrenzer oder Anschläge aufgrund von Kapillarkräften an oder entlang der Kante des Gutes nach oben gezogen wird. Dadurch gelangt die Flüssigkeit im Bereich dieser Begrenzer in unerwünschter Weise an die Oberseite des Gutes, was in vielen Fällen zu Ausschuss führt. Deshalb können derartige Begrenzer nicht in Fällen verwendet werden, in denen eine ungeschützte Oberseite noch nicht einmal partiell benetzt werden darf.

Die Druckschrift EP 0 434 434 A1 offenbart ebenfalls eine Vorrichtung, bei der die Einhaltung der Position eines von unten mit Behandlungsflüssigkeit angespülten flachen Gegenstandes durch die Verwendung seitlicher Begrenzer gewährleistet ist. Durch einen radial nach innen erfolgenden Flüssigkeitsstrom soll der flache Gegenstand im Bereich zwischen den Begrenzern zentriert werden können.

Weitere Galvanisiereinrichtungen für Wafer sind beispielsweise in DE 600 25 773 T2 (Fig. 1) und US 6,001,235 (Fig. 1) offenbart. Die elektrischen Kontakte zum Anschluss an die Badstromquelle ragen vertikal aus dem Elektrolyten heraus. Beim Metallisieren des Gutes werden auch die Kontakte bis zur Elektrolyt/Luft-Grenze metallisiert, zumindest bis zu einer möglichen partiellen Isolierbeschichtung. Da diese Isolierbeschichtung in der Praxis Verschleiß anfällig ist, wird gewöhnlich auf sie verzichtet, was auch deshalb erfolgt, weil die elektrische Isolierung an dem Grundwerkstoff, der gewöhnlich aus einem elektrochemisch inerten Metall wie Titan oder Niob besteht, nicht oder nur unzureichend haftet. Die unvermeidliche Oxidbildung an der Oberfläche dieser Metalle ist der Grund für die unzureichende Haftung einer solchen Isolierbeschichtung an den Kontakten. Die Metallisierung der metallisch blanken Kontaktbereiche muss daher während der fortlaufenden Produktion immer wieder entfernt werden. Hierzu werden die Kontakte im Behandlungsraum anodisch gegen eine kathodische Hilfselektrode geschaltet. Bei dieser elektrolytischen Entmetallisierung wird beobachtet, dass in unmittelbarer Nähe zur Elektrolyt/Luft-Grenze nur eine unvollständige Entfernung der metallisierten Schicht stattfindet. Als Ergebnis und ungeachtet mehrerer zwischengeschalteter Entmetallisierungsschritte lagert sich auf dem Kontakt in diesem Grenzbereich immer mehr Metall in einer mehr oder weniger ringförmigen Weise ab. Hinzu kommt, dass sich in diesem Bereich Kristalle des verwendeten Elektrolyten ablagern können. Eine automatische Entmetallisierung und Reinigung der Kontakte ist somit im Rahmen einer ununterbrochenen Produktion unzureichend. Von Zeit zu Zeit müssen manuelle Eingriffe zur Entfernung der störenden ringförmigen Ablagerungen erfolgen.

Dieses Problem der unzureichenden Entmetallisierung tritt auch bei Galvanisieranlagen auf, bei denen horizontal positionierte oder schräg gestellte Kontakte verwendet werden, die zugleich als Auflagen für das Gut dienen können. Ein Teil dieser Kontakte wird durch den aus dem Behandlungsraum ausströmenden Elektrolyten benetzt. Daher werden die mechanisch in Bezug zum Behandlungsraum permanent fixierten Kontakte bis zur Elektrolyt/Luft-Grenze metallisiert. Bei der elektrolytischen Entmetallisierung tritt die oben beschriebene unvollständige Entmetallisierung und Reinigung an dieser Grenze auf.

Die Aufgabe der vorliegenden Erfindung liegt in der Bereitstellung einer Vorrichtung und von Verfahren zur Überwindung der obigen Nachteile des Standes der Technik und zur Sicherstellung der einseitigen nasschemischen, elektrochemischen und/oder elektrolytischen Behandlung oder Reinigung einer vollständig flachen oder strukturierten Unterseite eines ebenen Gutes, welches über dem Behandlungsraum derart positioniert ist, dass auf das Gut nahezu keine horizontale Kraft einwirkt, die dasselbe verschieben könnte.

Mit anderen Worten ermöglicht die vorliegende Erfindung dem Anwender die ausschließliche Behandlung lediglich einer Seite eines ebenen Gutes, ohne dieses zu halten und/oder seitlich zu begrenzen, und ohne die andere Seite des Gutes gegen Benetzung zu schützen.

Dementsprechend wird die der vorliegenden Erfindung zugrunde liegende Aufgabenstellung durch Bereitstellung des Verfahrens gemäß Hauptanspruch gelöst. Bevorzugte Ausführungsformen sind Gegenstände entsprechender Unteransprüche.

Erfindungsgemäß werden mechanische Spannungen oder andere auf das Gut einwirkende Kräfte vermieden, um die Bruchgefahr für empfindliche Güter signifikant zu reduzieren.

Im Verlauf der Experimente, die zur vorliegenden Erfindung geführt haben, wurde zunächst versucht, die oben beschriebene Kapillarwirkung der seitlichen Begrenzer oder Endanschläge zu vermeiden, indem die Kontaktbereiche bis zu einem Linienkontakt zwischen den Begrenzern und der Kante des auf die Auflage(n) abgelegten Gutes reduziert wurden. Die partielle Benetzung der Oberseite des Gutes ließ sich wegen seiner gewöhnlich sehr geringen Dicke und der damit einhergehenden Kantenhöhe im Bereich von 0,1 mm bis 0,3 mm nicht verhindern. Da bereits kleine Flüssigkeitsmengen zu unerwünschten chemischen Reaktionen an der Oberseite führen können, wurde dieser Lösungsansatz verworfen.

Die Versuche ergaben jedoch überraschenderweise, dass die seitlichen Scherkräfte, die von einer entlang der Oberfläche eines Gutes strömenden Flüssigkeit ausgehen, praktisch kontrollierbar sind. Eine horizontale Raumveränderung des Gutes weg vom Zentrum der Prozesskammer ohne das Vorhandensein seitlicher Begrenzer oder Endanschläge konnte dann verhindert werden, wenn die Strömung der Behandlungsflüssigkeit, zumindest in der Nähe zum Gut, radial-symmetrisch von der Vertikallinie zu allen Seiten des Behandlungsraumes geführt wurde, und wenn das Gut in Kongruenz mit dem Behandlungsraum positioniert war. Durch eine Erhöhung der Präzision, insbesondere im Hinblick auf die obigen Symmetrien des experimentellen Versuchsaufbaus, war es möglich, das horizontale Wegdriften des Gutes aus seiner zentralen Lage ausreichend zu reduzieren. Das Gut verblieb auf den Auflagen, welche keinerlei seitlich wirkenden Begrenzer aufwiesen und im oberen Bereich der Behälterwandung des Behandlungsraumes angebracht waren, wenn die Spalthöhe in Bezug zur Überlaufkante entlang des gesamten Umfangs des Behandlungsraumes im Wesentlichen exakt dieselbe war, und wenn die Überlaufkante und der Spalt entlang des gesamten Umfangs exakt horizontal verliefen. Dies wurde erreicht, indem die die Prozesshöhe des Gutes in gleiche Höhe mit der Oberfläche der Behandlungsflüssigkeit gebracht wurden. Förderlich war dabei eine Variierbarkeit der Prozesshöhe durch Anpassung der Strömungsmenge bzw. der Höhenverstellbarkeit der Auflagen, sofern vorhanden. Sofern dabei mehr als eine Auflage verwendet wurde, erwies es sich auch als hilfreich, wenn die Auflagen zumindest nahezu symmetrisch zur vertikalen Mittenachse des Behandlungsraumes angeordnet waren. Wenngleich bevorzugt eine Vielzahl symmetrisch angeordneter Auflagen verwendet werden kann, kann die vorliegende Erfindung auch durch Verwendung einer Vorrichtung mit nur einer Auflage realisiert werden, die dann eine seitliche oder zentrale Auflage, oder eine durchgehend oder unterbrochen umlaufende, ringförmige Auflage sein kann. Im Folgenden wird das technische Merkmal dieser mindestens einen Auflage anhand einer Vorrichtung mit drei separaten und symmetrisch verteilten Auflagen veranschaulicht. Alternativ ist es auch möglich, dass eine Zentrierung des Gutes auch ohne jegliche Auflagen erfolgt. In diesem Falle erfolgt die Zentrierung alleine durch ein Kräftegleichgewicht, welches sich durch die allseitig gleichmäßig über die Überlaufkante ausströmende Behandlungsflüssigkeit ergibt. Untersuchungen zeigten außerdem, dass außermittig auf der Oberfläche der Behandlungsflüssigkeit positioniertes Gut aufgrund der zentrierenden Kräfte selbsttätig zur vertikalen Mittenachse der Prozesskammer zurückfand. Für den Fall einer nicht-runden Geometrie des Gutes zeigte sich weiterhin, dass das Gut in eine mit der Geometrie der Prozesskammer kongruente Position zurückfand.

Wird das Gut über dem Behandlungsraum auf die Oberfläche der überlaufenden Behandlungsflüssigkeit abgelegt, neutralisieren sich die horizontalen Komponenten der Adhäsionskraft zwischen dem Gut und der Behandlungsflüssigkeit nahezu vollständig. Dies ist insbesondere dann der Fall, wenn die Auflagen, sofern vorhanden, symmetrisch angeordnet sind und die Strömung der die Unterseite des Gutes kontaktierenden Behandlungsflüssigkeit radial-symmetrisch verläuft. Das einmal auf Auflagen ohne jegliche seitlichen Begrenzer abgelegte Gut verblieb in dieser Position, ohne dass irgendein Rahmen, Greifer, Halter oder irgendeine Auflage mit seitlichen Begrenzern zur Erzielung dieses Ergebnisses erforderlich war. Da demnach keine seitlichen Begrenzer vorhanden sind, kann keine Benetzung der Oberseite des Gutes stattfinden. Als weiterer Vorteil entfällt jegliche Notwendigkeit eines Schutzes der Oberseite, beispielsweise durch Beaufschlagung derselben mit einer Schutzschicht oder unter Zuhilfenahme einer mechanisch wirkenden Abdeckung oder eines Greifers wie einer gewöhnlich genutzten Vakuumspannvorrichtung. Außerdem wirken keine nachteiligen mechanischen Kräfte oder Spannungen auf das Gut.

Die Menge der in den Behandlungsraum einströmenden Behandlungsflüssigkeit wird mittels einer Pumpe und/oder Ventilen derart eingestellt, dass die Oberseite des Gutes, welches auf der Oberfläche der aus dem Behandlungsraum ausströmenden Behandlungsflüssigkeit abgelegt, nicht benetzt wird. Die Oberflächenspannung der Behandlungsflüssigkeit ist ausreichend, dass selbst die dünne Kante des Gutes von der Flüssigkeit nicht benetzt wird.

Weiterhin kann die Regelung der durch den Behandlungsraum (3) strömenden Menge an Behandlungsflüssigkeit dazu genutzt werden, dass das Gut allseitig gleichmäßig auf die gewünschte Prozesshöhe angehoben wird und dass es sich begrenzt durch die seitlich gleichmäßige Ausströmung der Behandlungsflüssigkeit eigenständig zentriert.

Die Behandlungsflüssigkeit wird permanent in den Behandlungsraum eingeleitet und fließt nach Benetzung der Unterseite des Gutes über eine Überlaufkante des Behandlungsraumes in einen Auffangbehälter. Hierdurch führen die vertikalen Komponenten der Adhäsion zwischen Gut und Behandlungsflüssigkeit am Rand des Gutes zu einer sanften Anhaftung des Gutes an die mindestens eine Auflage, sofern diese vorhanden ist. Bei einer elektrochemischen und/oder elektrolytischen Behandlung der Unterseite des Gutes ist diese mindestens eine Auflage elektrisch leitend und kann vorteilhafterweise zugleich als elektrischer Kontakt zur Übertragung des für die elektrolytische Behandlung des Gutes notwendigen Stromes dienen. Alternativ hierzu kann die elektrische Kontaktierung des Gutes durch Verwendung eines oder mehrerer separater Kontakte erfolgen, die mit der Unter- und/oder Oberseite des Gutes verbunden sind. Die Ausführungsform eines oder mehrerer integrierter mechanischer und elektrischer Kontakte ist jedoch bevorzugt. Durch die vertikal wirkenden Adhäsionskräfte wird eine sehr zuverlässige elektrische Kontaktierung erreicht. Zwischen den Auflagebereichen der Auflagen und der darauf liegenden Unterseite des Gutes wirkt in Folge der vertikalen Kraftkomponenten eine - wenn auch nur geringe - Reibung. Hierdurch wird die horizontale und zentrierte Lage des Gutes zusätzlich stabilisiert.

Die gewünschte Prozesshöhe, in der das zu behandelnde Gut gelagert ist, ist dadurch definiert, dass die Strömungsmenge derart eingestellt wird, dass der notwendige Flüssigkeitsaustausch zu einer homogenen Reaktion an der Oberfläche des Gutes führt. Durch die homogene Reaktion wird eine möglichst homogene Abscheidung, bzw. Abtragung (Ätzen) auf der zu behandelnden Substratseite erreicht.

Je nach beabsichtigtem Reaktionsmechanismus kann es vorteilhaft sein, das Gut über die sich aus dem Kräftegleichgewicht bzw. der Menge der ausströmenden Behandlungsflüssigkeit einstellende Prozess- bzw. Spalthöhe anzuheben. Hierzu können entweder die, sofern vorhanden, besonders bevorzugt höhenverstellbaren Auflagen, oder eine Erhöhung der Flussrate der Behandlungsflüssigkeit benutzt werden. Der erfindungsgemäße Aufbau ermöglicht es, das Gut beim Auflegen, Prozessieren und Abholen entweder auf die Flüssigkeitsoberfläche oder die Auflagen zu positionieren. Im Falle des Vorhandenseins von Auflagen lässt sich eine Fehlpositionierung bevorzugt dadurch ausgleichen, dass die Auflagen vorübergehend soweit abgesenkt und/oder die Strömungsmenge vorübergehend erhöht wird bzw. werden, so dass das Gut zeitweise frei aufschwimmt und sich selber zentrieren kann.

Die Oberfläche der elektrolytisch zu behandelnden Unterseite des Gutes muss zu ihrer elektrischen Kontaktierung unter Verwendung des mindestens einen Kontaktes mindestens einen Kontaktbereich umfassen, welcher elektrisch mit der zu behandelnden Oberfläche verbunden ist. Wenn das Gut an seiner Unterseite kontaktiert werden soll, muss dieser Kontaktbereich zur Ausgestaltung des mindestens einen Kontaktes passen, so dass der Strom in angemessener Weise an das Gut angelegt werden kann. Alternativ kann das Gut in bestimmten Fällen über seine trockene Oberseite kontaktiert werden, sofern die Unterseite elektrisch mit dieser Oberseite in Verbindung steht. Dies kann beispielsweise durch Bereitstellung mindestens eines außerhalb des Elektrolyten angeordneten elektrischen Kontaktes erreicht werden, wobei der Galvanisierstrom aus der Badstromquelle über die umlaufende Kante des Gutes und/oder durch das Gut hindurch an dasselbe geführt wird.

Bei Solarzellen, die bevorzugt aus p- und n-dotiertem Silizium bestehen, lässt sich diese elektrische Verbindung durch Beleuchtung der n-dotierten Unterseite herstellen. Dabei wirkt die Solarzelle ihrer eigentlichen Bestimmung entsprechend als Gleichstromquelle, die in Serie mit der beim Galvanisieren gleich gepolten Badstromquelle geschaltet ist. Eine ausreichend beleuchtete Solarzelle ist in der Lage, die für eine Galvanisierung erforderlichen Ströme in Höhe von 1 A und mehr zu führen. Ein Vorteil dieser Ausführungsform liegt darin, dass es an den trockenen Kontaktmitteln zu keiner Metallisierung kommt. Die erforderlichen Leuchtmittel einschließlich Reflektoren können innerhalb des Elektrolyten im Arbeitsbehälter und auch außerhalb des Behälters angeordnet sein. Die äußere Anordnung erfordert zumindest teilweise transparente Behälterwände des Behandlungsraumes. Als Leuchtmittel eignen sich alle bekannten Lichtquellen, wie insbesondere Halogenlampen und Leuchtdioden.

Nach einer bevorzugten Ausführungsform der vorliegenden Erfindung umfasst die Vorrichtung daher mindestens eine Lichtquelle zur Aktivierung lichtempfindlicher Komponenten der Behandlungsflüssigkeit und/oder zur Herbeiführung einer chemischen, elektrochemischen oder elektrolytischen Behandlung. Sie ist bevorzugt innerhalb des Behandlungsraumes angeordnet, kann aber auch außerhalb angeordnet sein. Diese mindestens eine Lichtquelle kann jedweder Art sein, einschließlich Halogenlampen, Leuchtdioden, Fluoreszenzlampen, ultraviolette oder infrarote Lichtquellen, Laser, oder Kombinationen derselben. Durch Verwendung einer Behandlungsflüssigkeit mit lichtaktivierbaren Komponenten in Kombination mit einer Lichtquelle erfolgt der Behandlungsprozess nur dann bzw. wird nur dann unterstützt, wenn die Lichtquelle eingeschaltet ist. Gewünschtenfalls kann die Aktivierung selektiv durch Verwendung geeigneter Masken gesteuert werden, die bestimmte Bereiche der Oberfläche des Gutes vor einer Beleuchtung schützen.

Nach einer weiteren bevorzugten Ausführungsform umfasst die Vorrichtung ferner mindestens ein Transportmittel zur Beförderung des Gutes zum und weg vom Behandlungsraum mit Mitteln zum Positionieren und Ablegen des Gutes auf der Flüssigkeitsoberfläche oder der mindestens einen Auflage oberhalb des Behandlungsraumes und zum Umpositionieren und Abheben des Gutes nach der Behandlung. Diese zuletzt genannten Mittel zum Be- und Entladen sind vorzugsweise so ausgestaltet, dass sie ausschließlich die Unterseite des Gutes berühren. Mit anderen Worten sollten Mittel vermieden werden, welche die Kante und/oder die Oberseite des Gutes berühren. Ein geeignetes Mittel umfasst ein oder mehrere stabförmige Elemente, welche gebogen und/oder stark abgewinkelt sind, damit die Unterseite eines auf der Oberfläche der Behandlungsflüssigkeit abgelegten Gutes erreicht wird, ohne dessen Kante zu berühren.

Die vorliegende Erfindung wird nachfolgend unter Bezugnahme auf die schematischen und nicht maßstabgetreuen Figuren 1 bis 6 detaillierter beschrieben.
Figur 1 zeigt die grundsätzliche Anordnung zur ausschließlich einseitigen nasschemischen Behandlung eines Gutes im Querschnitt und als Draufsicht.
Figur 2 zeigt die grundsätzliche Anordnung zur einseitigen elektrochemischen und/oder elektrolytischen Behandlung eines Gutes mit Einzelheiten des Kontaktbereiches.
Figur 3 zeigt unterschiedliche Ausführungsformen der Auflagen für das Gut und Einzelheiten des Auflagenbereichs.
Figur 4a zeigt Ausführungsformen der Überlaufkante des Behandlungsraumes in Seitenansicht.
Figur 4b zeigt Ausführungsformen der Überlaufkante des Behandlungsraumes im Querschnitt.
Figur 5 zeigt eine Anordnung mehrerer Behandlungsräume zur elektrochemischen und/oder elektrolytischen Metallisierung von Gütern innerhalb einer Fertigungsanlage.
Figur 6 zeigt eine Anordnung zur elektrolytischen Metallisierung von Silizium-Solarzellen mit beleuchteter Unterseite.

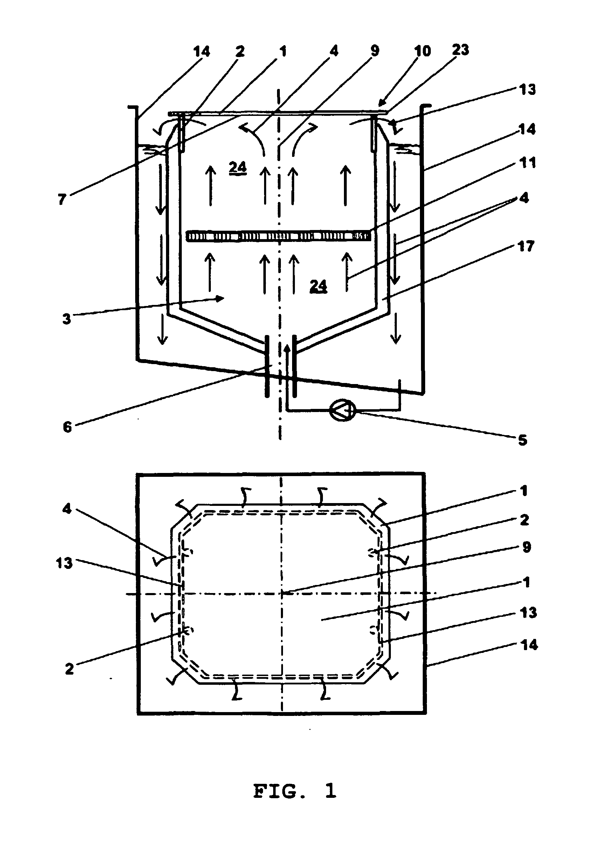

In Figur 1 ist das ebene Gut 1 auf den in der dargestellten Ausführungsform vorhandenen, jedoch für den erfindungsgemäßen Zentrierungseffekt nicht zwingend erforderlichen Kontakten oder Auflagen 2 oberhalb eines Behandlungsraumes 3 abgelegt. Die mindestens drei Auflagen 2 für ein kreisrundes Gut 1 oder die mindestens vier Auflagen 2 für ein eckiges Gut 1 sind am Rand des Behandlungsraumes 3 positioniert und symmetrisch zu seiner vertikalen Mittenachse 9 angeordnet. Auf diese Weise sind die Andruckkräfte zwischen dem Gut 1 und den hier stabförmigen Auflagen 2 nahezu identisch, was insbesondere zur Stromübertragung während einer elektrochemischen und/oder elektrolytischen Behandlung wichtig ist. Nach dieser Ausführungsform weist der Behandlungsraum 3 einen inneren Querschnitt auf, der weitgehend kongruent mit der Form und den Abmessungen des zu behandelnden Gutes 1 ist. Abweichend von dieser Kongruenz kann das Gut vorzugsweise geringfügig größer sein als der innere Querschnitt des Behandlungsraumes 3. In diesem Fall erfolgt im Randbereich 10 des Gutes eine geringfügig geringere oder, bei größeren Überhängen, keine Oberflächenbehandlung. Darüber hinaus kann das Gut 1 auch geringfügig kleiner als der Behandlungsraum 3 sein. Der innere Querschnitt kann kreisförmig, quadratisch oder rechteckig, mit oder ohne eingekürzte Ecken oder Rundungen, z.B. für Solarzellen, oder hiervon abweichend in einer anderen Form ausgestaltet sein. Die Überhänge sollten zumindest nahezu symmetrisch zur vertikalen Mittenachse 9 gewählt werden, damit auf das Gut 1 einwirkende horizontal resultierende Kräfte reduziert oder vermieden werden. Schließlich kann auch eine Deckungsungleichheit zwischen dem Querschnitt des Behandlungsraumes 3 und dem Gut 1 ausgewählt werden, um selektiv lediglich die Region des Gutes zu galvanisieren, welche mit der Behandlungsflüssigkeit 24 kontaktiert wird.

Um die Kosten und Anstrengungen im Falle einer Veränderung der Form des Gutes in Bezug auf die nicht veränderbare Außenform des Behandlungsraumes zu reduzieren, kann die innere Form des Behandlungsraumes angepasst werden durch Verwendung geeigneter Einsätze oder dergleichen, welche den Innendurchmesser und/oder die Form des Behandlungsraumes 3 entsprechend reduzieren.

In Figur 1 strömt die Behandlungsflüssigkeit beispielhaft zentral in den Behandlungsraum 3 ein. Dies wird symbolisch durch die Strömungspfeile 4 dargestellt. Zur Herbeiführung einer chemischen Modifikation des Gutes 1 wird die Behandlungsflüssigkeit mit Hilfe einer Pumpe 5 im Kreislauf durch eine in Form eines Rohres bereitgestellte Einlassöffnung 6 in den Behandlungsraum 3 in Richtung zur Unterseite 7 des zu behandelnden Gutes 1 gefördert. Alternativ können jedwede Mittel zum Einbringen der Behandlungsflüssigkeit in den Behandlungsraum genutzt werden, einschließlich passiver Mittel wie erhöht positionierte Flüssigkeitsbehälter. Die Behandlungsflüssigkeit wird an der Unterseite 7 radial nach außen zum Rand 10 des Gutes 1 gelenkt. Innerhalb des mit Behandlungsflüssigkeit gefüllten Behandlungsraumes, mindestens jedoch in der Nähe des Gutes, verläuft die Strömung radial-symmetrisch von der vertikalen Mittenachse 9 zu allen Seiten des Behandlungsraumes 3. Dies wird durch rotationssymmetrische (symmetrierende) Mittel 11 wie Blenden, Streublenden, durch ringförmige oder zentrale Einspeisung der Behandlungsflüssigkeit in den Boden des Behandlungsraumes 3, und/oder durch Verwendung mehrerer symmetrischer Mittel zur Einspeisung der Behandlungsflüssigkeit in den Bodenbereich des Behandlungsraumes 3 erreicht. Diese Flüssigkeit erzeugt Adhäsionskräfte, welche das auf der Flüssigkeitsoberfläche schwimmende Gut nach außen ziehen. Da die Strömung jedoch radial-symmetrisch verläuft, neutralisieren sich diese Kräfte gegenseitig, zumindest bis auf einen Toleranz bedingt unbedeutend kleinen Restbetrag. Zwischen der Überlaufkante 13 und dem auf den hier vorhandenen Auflagen 2 abgelegten Gut 1 bildet sich ein horizontaler Spalt, durch welchen die Behandlungsflüssigkeit allseitig aus dem Behandlungsraum 3 heraus- und in einen Äuffangbehälter 14 hineinströmen kann, wobei die Fallhöhe zur Vermeidung eines unerwünschten Lufteintrages klein eingestellt wird. Hierzu wird das Gesamtvolumen der Behandlungsflüssigkeit so groß gewählt, dass ihr Niveau im Auffangbehälter 14 nahe an die Überlaufkante 13 heranreicht. Eine Pumpe 5 fördert die Behandlungsflüssigkeit aus dem Auffangbehälter 14 zurück in den Behandlungsraum 3. Zur Einstellung der umlaufenden Flüssigkeitsmenge pro Zeiteinheit können ein in der Drehzahl veränderlicher Antrieb für die Pumpe oder innerhalb der Rohre befindliche einstellbare Drosseln, Ventile und dergleichen verwendet werden. Für ein Gut mit einer zu behandelnden Oberfläche von 1,5 dm² wurde das Durchflussvolumen in den Versuchen für jeden Behandlungsraum zwischen 3 und 20 Liter pro Minute eingestellt. Die jeweilige Menge ist in erster Linie Prozess bedingt. Erfindungsgemäße erlaubt die Fixierung des Gutes 1 oberhalb des Behandlungsraumes 3 ohne seitliche Begrenzer die Einstellung des Durchflussvolumens innerhalb des genannten weiten Bereiches, ohne dass es dabei zu einer Verschiebung des Gutes kommt. In Figur 1 zeigt eine Draufsicht eine typische Solarzelle mit eingekürzten Ecken. Der innere Querschnitt des Behandlungsraumes 3 hat die gleiche Form. Da die Überlaufkante 13 in dieser Zeichnung von dem Gut 1 verdeckt wird, ist sie gestrichelt dargestellt. Bei dieser Vorrichtung werden keine seitlichen Anschläge verwendet.

Sofern für eine spezifische Verfahrensgestaltung gewünscht, können in den Behandlungsraum 3 weitere rotationssymmetrische Mittel 11 eingebaut werden, die bevorzugt axialsymmetrisch zur vertikalen Mittenachse 9 ausgerichtet sind, wie Blenden, Membranen, Diaphragmen, lösliche oder unlösliche Anoden und andere Elektroden oder Betriebsmittel. Sie sind so ausgestaltet, dass die gleichmäßige symmetrische Strömung entlang des Gutes erhalten bleibt.

Für lösliche Anoden können sowohl selbsttragende Platten mit oder ohne Löcher als auch Schüttgut verwendet werden. Das z.B. in Form von Metallkugeln vorliegende Schüttgut liegt auf einem elektrisch leitfähigen und chemisch inerten Metallgitter, welches zugleich der elektrischen Verbindung mit einer Badstromquelle dient. Oben wird das Schüttgut von einem für Ionen durchlässigen Filtergewebe, z.B. aus Polypropylen, abgedeckt. Die Behandlungsflüssigkeit strömt zur Unterseite 7 des Gutes, während sie diese Anordnung passiert, welche insgesamt als Anode oder - im Rahmen der vorliegenden Beschreibung - allgemein als rotationssymmetrisches Mittel 11 bezeichnet wird.

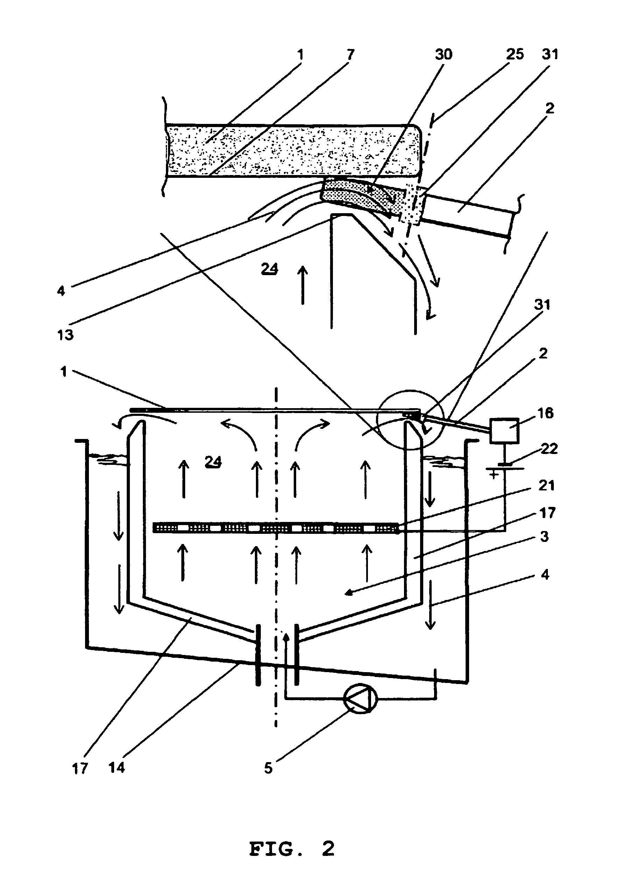

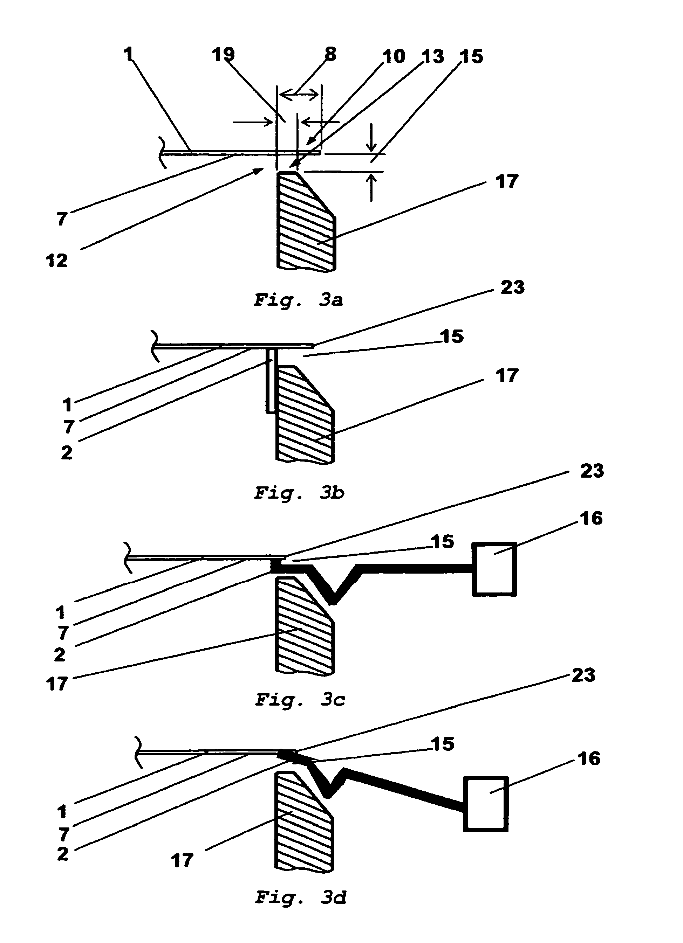

Im Falle des Vorhandenseins von Auflagen 2 bestimmen diese gemäß Darstellung in Figur 3b-d die Spalthöhe 15. Daher müssen sie mechanisch präzise nahe dem Behandlungsraum positioniert sein. Die mindestens eine Auflage kann aus einem elektrisch nicht-leitenden Werkstoff oder im Falle einer elektrochemischen und/oder elektrolytischen Behandlung des Gutes 1 aus Metall hergestellt sein. In diesem Fall dient diese mindestens eine Auflage vorzugsweise zugleich als elektrischer Kontakt 2 zur Stromübertragung auf das Gut 1. Die Auflage(n) 2 kann bzw. können gemäß Darstellung in Figur 1 an der Behälterwand 17, oder gemäß Darstellung in Figur 2 an gesonderten Auflagenträgern 16 befestigt sein.

Die Figur 2 veranschaulicht die elektrochemische und/oder elektrolytische Behandlung des Gutes 1. Innerhalb des Behandlungsraumes 3 ist eine lösliche oder unlösliche Anode 21 angeordnet. Zur Metallisierung wird das Gut 1 von einer Badstromquelle 22 kathodisch gegen die Anode 21 geschaltet. Daher werden die benetzte Unterseite 7 des Gutes 1 und die benetzten Bereiche der metallisch blanken Kontakte 2 durch den Elektrolyten bis zur Elektrolyt/Luft-Grenze 25 galvanisiert. In Abhängigkeit vom Elektrolyten, insbesondere von dessen Metallgehalt, können sich an dieser Grenze auch Kristalle ablagern. Sowohl die Kontaktmetallisierung 30 als auch die Kristallbildung sind für einen Dauerbetrieb einer Galvanisieranlage nachteilig. Nach jedem oder nach einigen Metallisierungsvorgängen müssen die Kontakte 2 elektrolytisch entmetallisiert und gereinigt werden. Hierzu werden sie anodisch gegen eine kathodisch geschaltete Gegenelektrode gepolt. Die elektrolytische Entmetallisierung erfolgt in diesem Bereich der Kontakte 2 jedoch nicht vollständig. Werden keine weiteren Maßnahmen ergriffen, führen bereits wenige Metallisierungs- und Entmetallisierungsvorgänge zu einer annähernd ringförmigen oder streifenförmigen Anlagerung des zu galvanisierenden Metalls auf den Kontakten im Bereich der Elektrolyt/Luft-Grenze 25. Diese störende Ablagerung wird nachfolgend als Metallring 31 bezeichnet und muss gewöhnlich manuell entfernt werden, wodurch der automatische Produktionsablauf unterbrochen wird.

Durch eine mehrfache Verlängerung der Entmetallisierungsdauer könnte der Metallring 31 vermutlich weitgehend elektrolytisch aufgelöst werden. Dies ist jedoch mit einer Reduzierung der Produktionskapazität der Anlage verbunden und sollte deshalb vermieden werden. Eine andere Möglichkeit zum elektrolytischen Auflösen oder Ätzen des Metallringes 31 wäre eine Steigerung der zirkulierenden Elektrolytmenge während der Entmetallisierung. Dies würde jedoch einen komplexeren Aufbau erfordern und den Nachteil aufweisen, dass es aufgrund einer forcierten und damit unruhigeren Strömung zu einem erhöhten Eintrag von Luft in den Elektrolyten kommt.

Die Luft wirkt auf die Additive des Elektrolyten ein und führt zu einem unvorteilhaften Anstieg seines Verbrauchs. Da die Entmetallisierungsdauer im Rahmen der vorliegenden Erfindung im Vergleich zur Galvanisierungsdauer jedoch vorzugsweise sehr kurz ist, hat eine vorübergehende Steigerung der Flussrate nur einen geringen Effekt auf das Elektrolytsystem.

Vorteilhafte Ausführungsformen der Auflagen 2 oder des Spaltes 12, welcher auch die Prozesshöhe definiert, sind in Figur 3 dargestellt.

Die Fig. 3a zeigt einen Spalt 12, welcher ohne das Vorhandensein von Auflagen durch die Überlaufkante 13 und die Unterseite des zu behandelnden Gutes gebildet wird. Zur Vermeidung einer Benetzung der Kante 23 des Gutes sollte ein Kontakt zwischen der Auflage 2, sofern vorhanden, und dem Gut 1 innerhalb dieses kritischen Bereichs vermieden werden. Dies wird durch die dargestellten Formen und Ausrichtungen der Auflagen 2 sowie durch den Überhang des Gutes in Bezug auf den Behälterrand erreicht. Zur Vermeidung einer Benetzung der Auflagenträger 16 mit der Behandlungsflüssigkeit können die Auflagen gemäß Darstellung siphonartig ausgebildet sein.

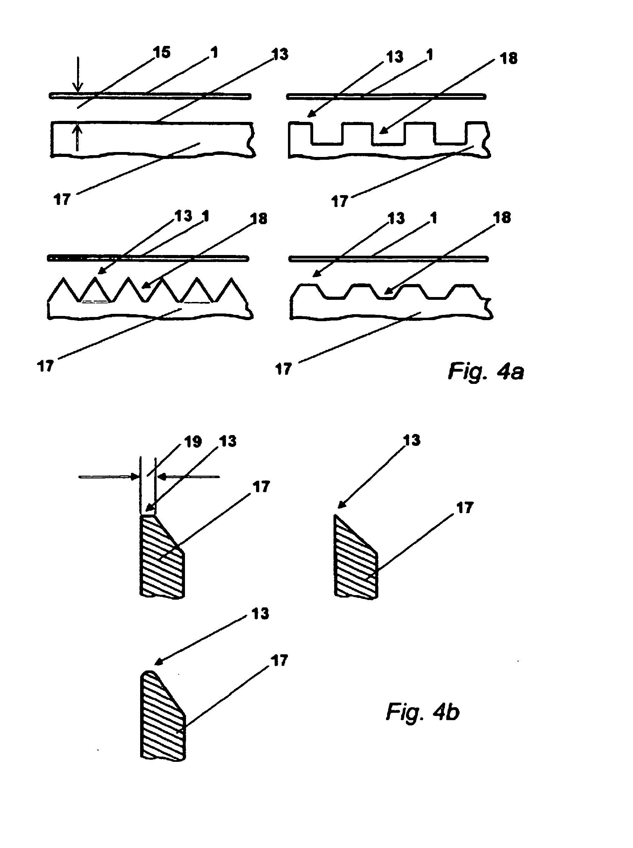

Die Figur 4a zeigt Ausführungsformen der Überlaufkante 13 in Seitenansicht. Bevorzugt wird eine gerade Kantenlinie verwendet. Wie in dieser Figur dargestellt ist, können die gesamte Überlaufkante 13 oder Teile davon verschieden gestaltete Einschnitte 18 aufweisen. Ähnlich den trapezförmigen Einschnitten kann auch ein sinusförmiger Verlauf gewählt werden. Diese Einschnitte dienen der individuellen Beeinflussung (Verringerung) der Strömungsgeschwindigkeit der Behandlungsflüssigkeit im Randbereich des Behandlungsraumes. Durch Einschnitte 18 an der Überlaufkante 13 kann die Abflussgeschwindigkeit der Behandlungsflüssigkeit daher für eine gegebene Durchflussmenge optimiert werden, damit die beabsichtigte gleichmäßige Behandlung des Gutes sichergestellt ist. Die Tiefe und die Beabstandung der Einschnitte 18 liegen im Bereich von 0,5 mm bis 5 mm. In Abhängigkeit des Verfahrens kann die Spalthöhe 15 zwischen 0,3 mm und 6 mm variieren und liegt bevorzugt zwischen 1 mm bis 3 mm. Die Spalthöhe 15 wird von dem höchsten Punkt der Einschnitte 18 gemessen.

Die Figur 4b zeigt im Querschnitt verschiedene Ausführungsformen der Behälterwand 17 im Bereich der Überlaufkante 13. Die Form des Querschnitts hängt vom Prozess ab. Die abgerundete Überlaufkante verringert eine Wirbelbildung in diesem Bereich. Für Wafer oder Solarzellen üblicher Abmessungen kann die Dicke 19 der Überlaufkante zwischen einer scharfen Kante (mehr als 0,0 mm) und 5 mm und vorzugsweise zwischen 0,5 mm und 2,5 mm liegen.

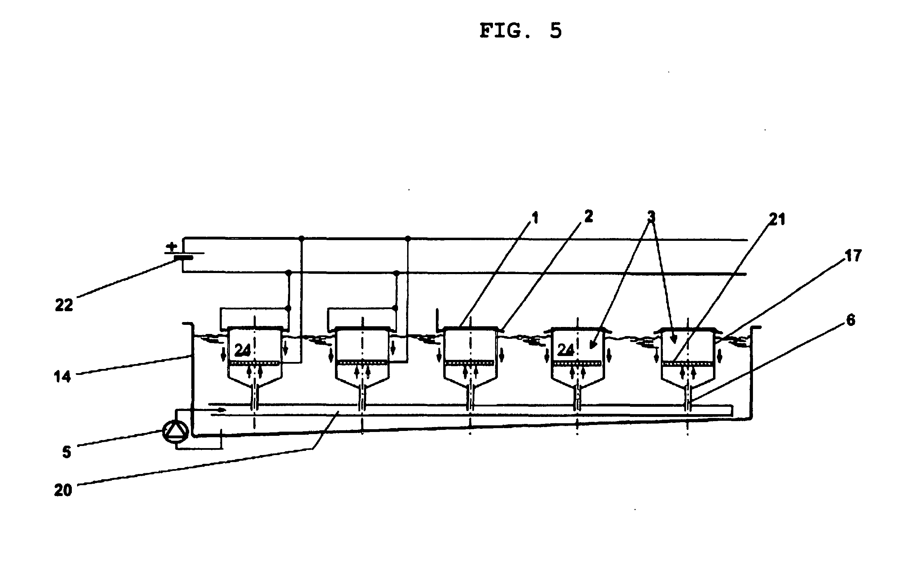

Die Figur 5 zeigt eine Mehrzahl von Behandlungsräumen 3, wie sie in einer größeren Produktionsanlage nebeneinander oder hintereinander angeordnet sind. Der Auffangbehälter 14 nimmt die überlaufende Behandlungsflüssigkeit aus einem, mehreren oder allen Behandlungsräumen 3 auf. Eine gemeinsame Pumpe 5 fördert die Behandlungsflüssigkeit in ein Verteilerrohr 20, das mit den Behandlungsräumen 3 über zentrale Einlassrohre 6 in Verbindung steht. Zur Vermeidung ungleicher Durchflussvolumina in den parallel gespeisten Behandlungsräumen 3 kann das Verteilerrohr 20 mit einem inneren Rohr in gleicher Länge mit Öffnungen ausgestattet sein, in welche die Behandlungsflüssigkeit von der Pumpe zuerst eingespeist wird. Von dort erreicht die Flüssigkeit dann das Verteilerrohr 20.

In diesem Ausführungsbeispiel umfasst ein jeder Behandlungsraum 3 eine lösliche oder unlösliche Anode 21, die bevorzugt Öffnungen aufweist, durch welche der für die elektrochemische oder elektrolytische Behandlung des Gutes 1 benötigte Elektrolyt hindurchfließen kann. Zur Metallisierung wird das Gut 1 von einer Badstromquelle 22 kathodisch geschaltet. Geeignet ist auch eine unipolare oder bipolare Pulsstromquelle. Eine Badstromquelle 22 kann mehrere Behandlungsräume 3 mit Badstrom zum Galvanisieren versorgen. Das Be- und Entladen der Behandlungsräume 3 mit Gütern erfolgt vorzugsweise parallel, d.h. gleichzeitig, mit nicht dargestellten Transportmitteln. Dadurch werden in der gesamten Produktionsanlage weniger Transportmittel benötigt.

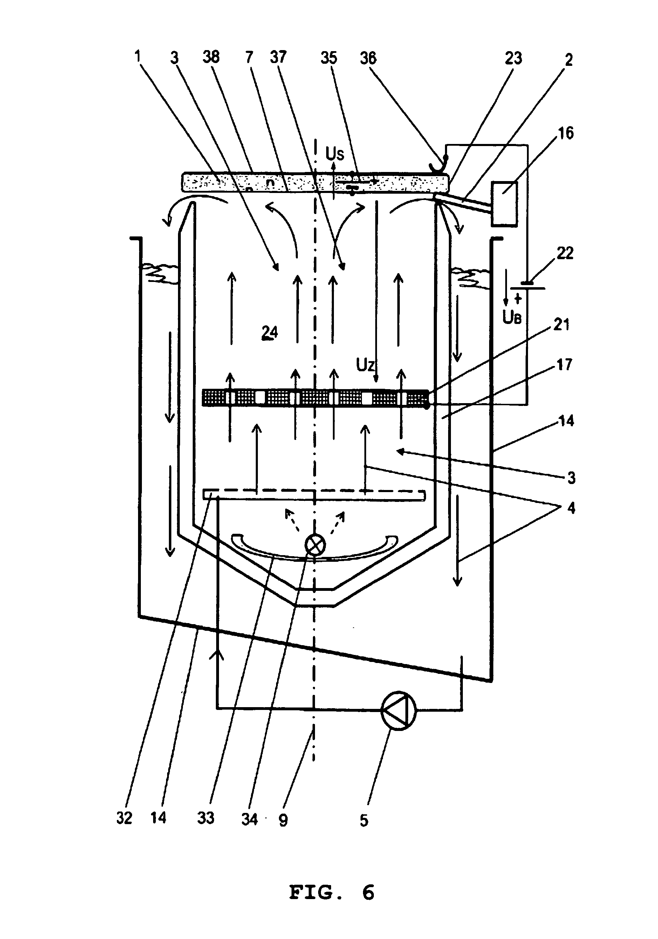

Die Figur 6 zeigt einen weiteren Behandlungsraum mit einer elektrolytischen Zelle 37. Bei dem Gut 1 handelt es sich um eine Solarzelle mit p- und n-dotierten Bereichen, die beleuchtet wird. Wie bei den anderen Beispielen steht lediglich die zu behandelnde Unterseite 7 in Kontakt mit dem Elektrolyten 24 des Behandlungsraumes 3. Die elektrisch leitfähige Oberseite 38 der Solarzelle soll nicht metallisiert werden. Bei derartigen Solarzellen kann die elektrische Kontaktierung unter Verwendung der trockenen Oberseite 38 erfolgen, wenn die galvanisierte Unterseite 7 beleuchtet wird. In diesem Fall entfällt die ansonsten erforderliche Entmetallisierung der Kontaktmittel.

Die beleuchtete Solarzelle stellt elektrisch eine Gleichstromquelle 35 dar, deren Ersatzschaltbild eingetragen ist. Diese Gleichstromquelle 35 generiert eine elektromotorische Kraft (EMK) in Form der Solarzellenspannung U_{S}, die in Abhängigkeit von der Beleuchtungsstärke etwa 0,6 Volt erreicht. Diese Gleichstromquelle 35 befindet sich stromführend im Galvanisierstromkreis, der aus der Badstromquelle 22, den elektrischen Oberseitenkontakten 36, der Gleichstromquelle 35, der zu behandelnden Unterseite 7, dem Elektrolyten 24 in der elektrolytischen Zelle 37, und einer löslichen oder unlöslichen Anode 21 besteht. Die Polaritäten der beteiligten Spannungen dieses Galvanisierstromkreises sind angegeben. Dabei handelt es sich um die Klemmenspannung U_{B} der Badstromquelle 22, die als elektromotorische Kraft EMK auftretende Solarzellenspannung U_{S}, und die Zellspannung U_{Z} der elektrolytischen Zelle, die als Spannung an der Last bzw. am Verbraucher anliegt. Wegen der Serienschaltung der beiden treibenden Spannungen ist die Klemmenspannung U_{B} der Badstromquelle 22 geringer als die Zellspannung U_{Z}, da sie annähernd auf den Betrag der EMK reduziert ist.

Die Unterseite 7 des Gutes 1 wird von einem Lichtquelle 34 beleuchtet. Geeignete Lichtquellen bieten ein Lichtspektrum, das annähernd dem Sonnenlicht entspricht. Gewünschtenfalls kann das Licht mittels eines Reflektors 33 verstärkt und/oder auf das Gut 1 ausgerichtet werden. Durch die Beleuchtung generiert die Solarzelle eine EMK von ungefähr 0,6 Volt mit kleinem Innenwiderstand. Dieser Widerstand einer Solarzelle aus Silizium mit einer Oberfläche von 1 bis 2 dm² kann den Galvanisierstrom in der Größenordnung von 1 Ampere und größer sicher führen. Die Lichtquelle 34 kann sich auch außerhalb eines zumindest teilweise transparenten Behandlungsraumes befinden.

Der Elektrolyt kann beispielsweise durch einen Verteilerring 32 symmetrisch in den Behandlungsraum 3 eingespeist werden. Hierdurch wird ein Abblenden des von der Lichtquelle ausgehenden Lichtes vermieden.

Die Erfindung eignet sich neben sämtlichen üblichen nasschemischen Behandlungen insbesondere für alle typischen elektrolytischen Anlagen sowie für alle ebenen Güter wie Wafer, Solarzellen, Leiterplatten und Hybride. Darüber hinaus können alle zum elektrolytischen Abscheiden und Auflösen geeigneten Metalle Anwendung finden, wie zum Beispiel Kupfer, Nickel, Zinn und Silber. Die erfindungsgemäße Vorrichtung ist auch für ein elektrolytisches Ätzen mit umgekehrter Polarität der Badstromquelle geeignet. Hierzu ist innerhalb des Behandlungsraumes 3 eine Gegenelektrode angeordnet, die das geätzte Metall aufnimmt. Diese Elektrode wird nach längerer Betriebszeit ausgetauscht.

### Bezugszeichenliste

- 1: Gut, Wafer, Solarzelle
- 2: Auflage, Kontakt
- 3: Behandlungsraum
- 4: Strömungspfeil
- 5: Pumpe
- 6: Einlassrohr
- 7: Unterseite des Gutes
- 8: Überhang
- 9: vertikale Mittenachse
- 10: Rand des Gutes
- 11: rotationssymmetrisches Mittel, symmetrierendes Mittel
- 12: Spalt
- 13: Überlaufkante
- 14: Auffangbehälter
- 15: Spalthöhe
- 16: Auflagenträger, Kontaktträger
- 17: Behälterwand
- 18: Einschnitte
- 19: Kantendicke
- 20: Verteilerrohr
- 21: Anode
- 22: Badstromquelle
- 23: Kante des Gutes
- 24: Elektrolyt, Behandlungsflüssigkeit
- 25: Elektrolyt/Luft-Grenze
- 26: Gasstrom, Luftstrom
- 27: Öffnung, Düse
- 28: Gasverteiler, Gasverteilerrohr
- 29: Ventil
- 30: Kontaktmetallisierung
- 31: Metallring
- 32: Elektrolytverteiler, Verteilerring
- 33: Reflektor
- 34: Lichtquelle
- 35: Gleichstromquelle
- 36: elektrischer Oberseitenkontakt
- 37: elektrolytische Zelle
- 38: Oberseite des Gutes

- U_{S}: Solarzellenspannung
- U_{B}: Klemmenspannung
- U_{Z}: Zellspannung

## Patentansprüche

1. Verfahren zur ausschließlich einseitigen nasschemischen, elektrochemischen oder elektrolytischen Behandlung oder zur Reinigung der vollständig flachen oder strukturierten Unterseite (7) eines ebenen Gutes (1) mit einer Behandlungsflüssigkeit unter Verwendung eines Behandlungsraumes (3), der mindestens eine Öffnung, durch welche die Behandlungsflüssigkeit in den Behandlungsraum einströmt und diesen befüllt, eine am oberen Rand als Auslass für die Behandlungsflüssigkeit dienende Überlaufkante (13), und einem Auffangbehälter (14) aufweist, umfassend die folgenden Schritte:
a) Transportieren, Positionieren sowie Ablage des Gutes (1) auf der Oberfläche der Behandlungstltissigkeit durch ein Transportmittel;
b) Entfernung des Transportmittels vom Gut (1), so dass das Gut mit seiner Unterseite (7) frei auf der Oberfläche der Behandlungsflüssigkeit aufschwimmt;
c) Stabilisierung der Position durch eigenständige Zentrierung des frei aufschwimmenden Gutes (1), indem der den Behandlungsraum (3) durchströmende und die Unterseite (7) des Gutes benetzende Flüssigkeitsstrom zumindest in der Nähe des Gutes gleichmäßig in Richtung aller Seiten des Behandlungsraumes nach außen bis zum Rand des Gutes und über die Überlaufkante (13) geführt wird, wodurch sich die horizontalen Kraftkomponenten der Adhäsion zwischen Gut und Behandlungsflüssigkeit gegenseitig nahezu neutralisieren und die vertikalen Komponenten der Adhäsion zwischen Gut und Behandlungsflüssigkeit am Rand des Gutes zu einer Anhaftung desselben auf der Flüssigkeitsoberfläche führen;
d) Herbeiführung der Behandlung oder Reinigung des eigenständig zentrierten Gutes (1) durch weitere Kontaktierung desselben mit der Behandlungsflüssigkeit, ohne dass das Gut während der Behandlung oder Reinigung über dem Behandlungsraum (3) gehalten oder seitlich begrenzt wird;
e) Aufnahme des Gutes von der Oberfläche der Behandlungsflüssigkeit nach erfolgter Behandlung oder Reinigung durch ein Transportmittel.

2. Verfahren nach Anspruch 1, **dadurch gekennzeichnet, dass** der zur elektrolytischen Behandlung des Gutes erforderliche Strom mittels mindestens eines elektrisch leitenden Kontaktes angelegt wird.

3. Verfahren nach Anspruch 1 oder 2, **dadurch gekennzeichnet, dass** der Behandlungsraum (3) mindestens eine Auflage (2) aufweist und das Gut (1) vor seiner Behandlung oder Reinigung gemäß Schritt d) von dieser mindestens einen Auflage gestützt wird.

4. Verfahren nach Anspruch 3, **dadurch gekennzeichnet, dass** die mindestens eine Auflage (2) in der Höhe verstellbar ist.

5. Verfahren nach Anspruch 3 oder 4, **dadurch gekennzeichnet, dass** die mindestens eine Auflage (2) elektrisch leitend ist und als der mindestens eine Kontakt verwendet wird.

6. Verfahren nach einem der vorhergehenden Ansprüche, **dadurch gekennzeichnet, dass** der entlang der Unterseite (7) des Gutes (1) nach außen gerichtete Flüssigkeitsstrom durch (a) Verwendung rotationssymmetrischer Mittel (11, 21), (b) ringförmiges oder zentrales Einspeisen der Behandlungsflüssigkeit in den Boden des Behandlungsraumes (3), und/oder (c) durch Verwendung einer Mehrzahl symmetrischer Mittel zur Einspeisung der Behandlungsflüssigkeit in den Bodenbereich des Behandlungsraumes (3) bereitgestellt wird.

7. Verfahren nach einem der vorhergehenden Ansprüche, **dadurch gekennzeichnet, dass** die Abflussgeschwindigkeit der mit einer gegebenen Flussrate zirkulierenden Behandlungsflüssigkeit durch Einschnitte (18) an der Überlaufkante (13) variiert wird.

8. Verfahren nach einem der vorhergehenden Ansprüche, **dadurch gekennzeichnet, dass** der Behandlungsraum (3) einen kreisförmigen, quadratischen oder rechteckigen Querschnitt mit oder ohne eingekürzte Ecken aufweist, so dass das Behandlungsgut (1) kongruent mit dem Behandlungsraum positioniert werden kann.

9. Verfahren nach einem der vorhergehenden Ansprüche, **dadurch gekennzeichnet, dass** die elektrolytische Behandlung des Gutes durch Verwendung von Gleichstrom, unipolarem oder bipolarem Pulsstrom erfolgt.

10. Verfahren nach einem der vorhergehenden Ansprüche, **dadurch gekennzeichnet, dass** das zu behandelnde ebene Gut (1) eine Solarzelle ist, und dass die elektrolytische Behandlung dieser Solarzelle durch Beleuchtung ihrer Unterseite (7) herbeigeführt wird.

11. Verfahren nach Anspruch 10, **dadurch gekennzeichnet, dass** die elektrische Kontaktierung des Gutes außerhalb des Elektrolyten erfolgt.

12. Verfahren nach einem der vorhergehenden Ansprüche, **dadurch gekennzeichnet, dass** mindestens eine innerhalb des Behandlungsraumes (3) angeordnete Lichtquelle (34) zur Aktivierung von lichtempfindlichen Komponenten der Behandlungsflüssigkeit und/oder zur Herbeiführung oder Unterstützung einer chemischen, elektrochemischen oder elektrolytischen Behandlung verwendet wird.

13. Verfahren nach einem der vorhergehenden Ansprüche, **dadurch gekennzeichnet, dass** die Behandlung das Galvanisieren von Solarzellen aus Silizium betrifft.

## Claims

1. Method for the exclusive single sided wet chemical, electrochemical or electrolytic treatment or for the cleaning of the entirely flat or structured underside (7) of a flat good (1) with a treatment liquid by use of a treatment chamber (3) which has at least one opening through which the treatment liquid streams into the treatment chamber and fills the same, an overflow edge (13) which is arranged at the upper edge and serves as outlet for the treatment liquid, and a receiver tank (14), comprising the following steps:
a) transporting, positioning as well as deposition of the good (1) onto the surface of the treatment liquid by a transport means;
b) removal of the transport means from the good (1) such that the good with its underside (7) floats freely on the surface of the treatment liquid;
c) stabilization of the position by self-centering of the free floating good (1), wherein the liquid stream which streams through the treatment chamber (3) and wets the underside (7) of the good is, at least in the proximity of the good, uniformly guided towards all sides of the treatment chamber to the outward direction up to the border of the good and over the overflow edge (13), whereby the horizontal force components of the adhesion between good and treatment liquid nearly neutralize each other, and the vertical components of the adhesion between good and treatment liquid at the border of the good result in an adherence of the same to the liquid surface;
d) effecting the treatment or the cleaning of the self-centered good (1) by further contacting the same with the treatment liquid, without the good being held or laterally limited above the treatment chamber (3) during the treatment or cleaning;
e) taking-up of the good from the surface of the treatment liquid after completed treatment or cleaning by means of a transport means.

2. Method according to claim 1, **characterized in that** the current which is necessary for the electrolytic treatment of the good is applied by means of at least one electrically conducting contact.

3. Method according to claim 1 or 2, **characterized in that** the treatment chamber (3) has at least one support (2), and the good (1) is supported by means of this at least one support prior to its treatment or cleaning according to step d).

4. Method according to claim 3, **characterized in that** the at least one support (2) is vertically adjustable.

5. Method according to claim 3 or 4, **characterized in that** the at least one support (2) is electrically conductive and is used as the at least one contact.

6. Method according to any of the preceding claims, **characterized in that** the liquid stream which is directed along the underside (7) of the good (1) to the outward direction is provided by (a) usage of rotation-symmetric means (11, 21), (b) annular or central supply of the treatment liquid into the bottom of the treatment chamber (3), and/or (c) usage of a multitude of symmetric means for supply of the treatment liquid into the bottom region of the treatment chamber (3).

7. Method according to any of the preceding claims, **characterized in that** the discharge velocity of the treatment liquid which circulates with a given flow rate is varied by means of incisions (18) at the overflow edge (13).

8. Method according to any of the preceding claims, **characterized in that** the treatment chamber (3) has a circular, quadratic or rectangular cross section with or without shortened corners, such that the treatment good (1) can be positioned congruently with the treatment chamber.

9. Method according to any of the preceding claims, **characterized in that** the electrolytic treatment of the good is effected by usage of direct current, unipolar or bipolar pulse current.

10. Method according to any of the preceding claims, **characterized in that** the flat good (1) to be treated is a solar cell, and that the electrolytic treatment of this solar cell is effected by illumination of its underside (7).

11. Method according to claim 10, **characterized in that** the electrical contacting of the good takes place outside of the electrolyte.

12. Method according to any of the preceding claims, **characterized in that** at least one light source (34) being arranged inside the treatment chamber (3) is used for the activation of photosensitive components of the treatment liquid and/or for effecting or supporting a chemical, electrochemical, or electrolytic treatment.

13. Method according to any of the preceding claims, **characterized in that** the treatment relates to the electroplating of solar cells made from silicon.

## Revendications

1. Procédé pour le traitement chimique en milieux aqueux, électrochimique ou électrolytique exclusivement d'un seul coté ou pour le nettoyage du coté inférieur (7) complètement plat ou structuré d'un article plat (1) avec un liquide de traitement, utilisant une chambre de traitement (3) qui présente au moins une ouverture à travers laquelle le liquide de traitement coule dans la chambre de traitement et la remplit, un seuil d'écoulement (13) au bord supérieur qui sert de sortie pour le liquide de traitement, et un récipient de récupération (14), comprenant les étapes suivantes:
(a) transport, positionnement ainsi que placement de l'article (1) sur la surface du liquide de traitement par un agent de transport;
(b) retrait de l'agent de transport de l'article (1) de telle manière que l'article surnage librement sur sa face inférieure (7) à la surface du liquide de traitement;
(c) stabilisation de la position grâce un centrage autonome de l'article (1) surnageant librement en guidant le courant de liquide coulant dans la chambre de traitement (3) et mouillant le coté inférieur (7) de l'article, de manière égale, au moins à proximité de l'article, en direction de tous les cotés de la chambre de traitement vers l'extérieur jusqu'au bord de l'article et au dessus du seuil d'écoulement (13), moyennant quoi les composants horizontaux de la force d'adhésion entre l'article et le liquide de traitement se neutralisent presque les uns les autres, et les composants verticaux de l'adhésion entre l'article et le liquide de traitement produisent au bord de l'article une adhérence de celui-ci sur la surface du liquide;
(d) mise en oeuvre du traitement ou nettoyage de l'article (1) centré de manière autonome par la poursuite du contact de celui-ci avec le liquide de traitement sans que l'article pendant le traitement ou nettoyage soit tenu ou encadré au-dessus de la chambre de traitement (3);
(e) levée de l'article de la surface du liquide de traitement à la fin du traitement ou nettoyage par un agent de transport.

2. Procédé selon la revendication 1, **caractérisé en ce que** le courant nécessaire au traitement électrolytique de l'article est appliqué au moyen d'au moins un contact conducteur électrique.

3. Procédé selon la revendication 1 ou la revendication 2, **caractérisé en ce que** la chambre de traitement (3) présente au moins un support (2) et l'article (1) est soutenu par ce, au moins un, support avant son traitement ou nettoyage selon l'étape (d).

4. Procédé selon la revendication 3, **caractérisé en ce que** ce, au moins un, support (2) est réglable en hauteur.

5. Procédé selon la revendication 3 ou la revendication 4, **caractérisé en ce que** ce, au moins un, support (2) est conducteur pour l'électricité et est utilisé en tant que le, au moins un, contact.

6. Procédé selon une des revendications précédentes, **caractérisé en ce que** le courant de liquide dirigé le long du coté inférieur (7) de l'article (1) vers l'extérieur est produit grâce à (a) l'utilisation des agents à rotation symétrique (11, 21), (b) l'alimentation en cercle ou centrale du liquide de traitement à partir du fond de la chambre de traitement (3), et/ou (c) l'utilisation de plusieurs agents symétriques pour l'alimentation en liquide de traitement dans la région du fond de la chambre de traitement (3).

7. Procédé selon une des revendications précédentes, **caractérisé en ce que** la vitesse d'écoulement du liquide de traitement circulant avec un débit donné est modifiée par des encoches (18) du seuil d'écoulement (13).

8. Procédé selon une des revendications précédentes, **caractérisé en ce que** la chambre de traitement (3) présente une section transversale circulaire, carrée ou rectangulaire avec ou sans coins coupés, de telle manière que l'article à traiter (1) peut être positionné en congruence avec la chambre de traitement.

9. Procédé selon une des revendications précédentes, **caractérisé en ce que** le traitement électrolytique de l'article se produit en utilisant un courant continu, un courant pulsé unipolaire ou bipolaire.

10. Procédé selon une des revendications précédentes, **caractérisé en ce que** l'article plat à traiter (1) est une cellule photovoltaïque et que le traitement électrolytique de cette cellule photovoltaïque est produit par une illumination de son coté inférieur (7).

11. Procédé selon la revendication 10, **caractérisé en ce que** le contact électrique de l'article se produit en dehors de l'électrolyte.

12. Procédé selon une des revendications précédentes, **caractérisé en ce que** au moins une source de lumière (34) localisée dans la chambre de traitement (3) est utilisée pour l'activation des composants sensibles à la lumière du liquide de traitement et/ou pour la production ou le renforcement d'un traitement chimique, électrochimique ou électrolytique.

13. Procédé selon une des revendications précédentes, **caractérisé en ce que** le traitement concerne la galvanisation de cellules photovoltaïques en silicium.
